# EUROPEAN PATENT SPECIFICATION

(11) **EP 0 713 251 B1**
(45) Date of publication and mention of the grant of the patent: **07.01.1999**
(21) Application number: 96100276.3
(22) Date of filing: 11.11.1993
(51) Int. Cl.: H02M 7/5387, H05K 7/06, H01L 23/64

(54) **Semiconductor conversion device**
Halbleiter-Umwandlungsvorrichtung
Dispositif de conversion à semi-conducteur

(30) Priority: 18.11.1992 JP 307397/92
(43) Date of publication of application: 22.05.1996
(62) Divisional of application: 93309047.4
(73) Proprietor: FUJI ELECTRIC CO. LTD., Kawasaki 210 (JP)
(72) Inventor: Terasawa, Noriho, Matsumoto City, Nagano (JP)
(74) Representative: Bridge-Butler, Alan James

(56) References cited:
- EP-A- 0 166 968
- DE-A- 4 102 574
- US-A- 4 514 749
- US-A- 4 831 497
- US-A- 5 057 970
- US-A- 5 077 595
- PATENT ABSTRACTS OF JAPAN vol. 14, no. 239 (E-930) 4182 21 May 1990 & JP-A-02 065 238 (SEIKO EPSON CORP.) 05 March 1990
- PATENT ABSTRACTS OF JAPAN vol. 8, no. 63 (E-233) 24 March 1984 & JP-A-58 213 456 (NIPPON DENKI) 12 December 1983

## Description

The present invention relates to a semiconductor conversion device comprising semiconductor switching elements in a main circuit configured as a bridge circuit, and particularly concerns the configuration of a drive circuit delivering drive signals which cause the switching elements to perform switching operations.

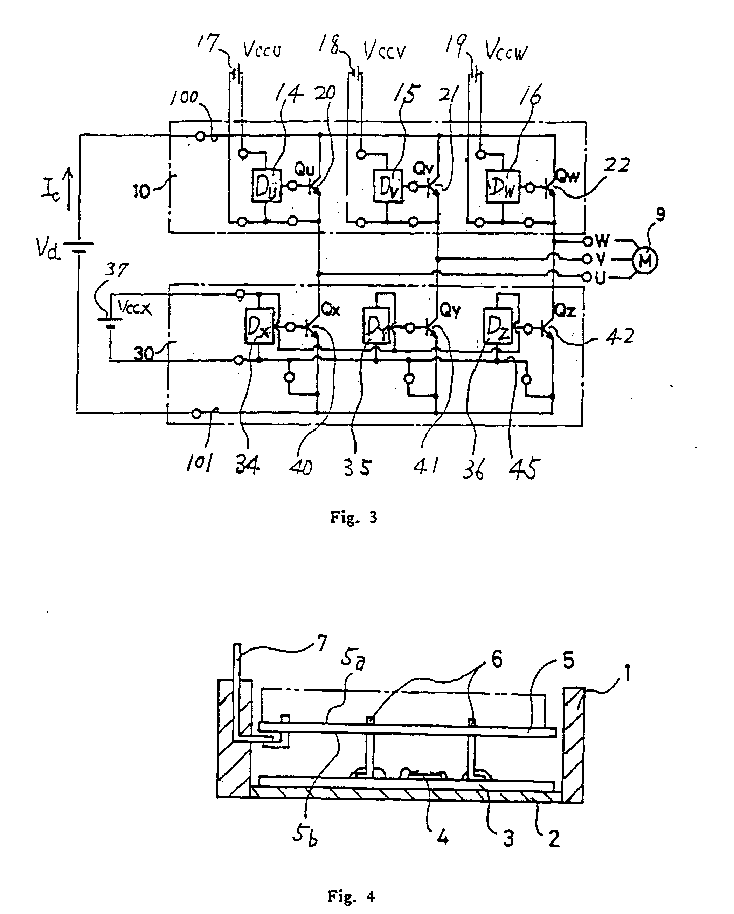

Semiconductor conversion devices having semiconductor switching elements in a main circuit configured as a bridge circuit and converting direct currents to alternating currents and vice versa in order to supply converted currents to loads have already been used as inverters or the like for electric power and many other applications. Such semiconductor conversion devices generally include three-phase inverter circuits that convert direct currents to three-phase alternating currents with a variable frequency. Figure 3 of the accompanying drawings shows an example of such a three-phase inverter circuit. This three-phase inverter is a semiconductor conversion device which has a three-phase bridge circuit configuration, and which supplies three-phase alternating currents to an electric motor 9 using a main DC power supply Vd. The three-phase inverter consists of an upper-arm circuit 10 which controls the high electrical potential side of the three-phase alternating voltage and a lower-arm circuit 30 which controls the low electrical potential side of the three-phase alternating voltage.

The upper-arm circuit 10 comprises a main circuit and a drive circuit. The main circuit in the upper arm circuit 10 is composed of bipolar transistors 20 to 22, which are known as semiconductor switching elements and are provided for the U, V, and W arms, respectively. The drive circuit in the upper arm circuit 10 is composed of individual drive circuits 14 to 16 (referenced D_{U} D_{V} and D_{W} in the Figure) which individually deliver drive signals that cause the respective transistors 20 to 22 to perform switching operations. Supplementary DC power supplies 17 to 19 are separately insulated from the outside, and control signals (not shown) are input to the respective individual drive circuits 14 to 16.

The lower-arm circuit 30 has almost the same configuration as the upper-arm circuit 10. The main circuit in the lower-arm circuit 30 is composed of bipolar transistors 40 to 42, which are known as semiconductor switching elements and are provided for the X, Y, and Z arms, respectively. The drive circuit in the lower-arm circuit 30 is composed of individual drive circuits 34 to 36 (referenced D_{X} D_{Y} and D_{Z} in the Figure) which individually deliver drive signals that cause the respective transistors 40 to 42 to perform switching operations. A common outside supplementary DC power supply 37 and control signals (not shown) are input to the individual drive circuits 34 to 36.

The three-phase inverter comprising the circuit configuration shown in Figure 3 is supplied with main DC electric currents Ic from the main DC power supply (Vd) through a positive-electrode main circuit line 100 and a negative-electrode main circuit line 101. The switching operations of the transistors 20 to 22 and 40 to 42 allow the DC-side main electric currents to start from the positive electrode of the main DC power supply (Vd) and flow through the main circuit line 100, one of the transistors 20 to 22, the electric motor 9, one of the transistors 40 to 42, and the main circuit line 101, in that order, and finally to reach the negative electrode of the main DC power supply (Vd) and supply three-phase alternating voltage to the electric motor 9.

Two circuit substrates, shown in Figure 4, are often used to configure a three-phase inverter with the above circuit configuration. That is, the main circuit composed of transistors 20 to 22 and 40 to 42 is configured on a main circuit substrate 3, onto which a semiconductor chip 4 having the required functions is mounted. In addition, the individual drive circuits 14 to 16 and 34 to 36 are configured on a drive circuit substrate 5, onto which these individual drive circuits are integrally mounted. Both the main circuit substrate 3 and drive circuit substrate 5 are housed within a container consisting of a case 1 and a base 2, which has good thermal conductivity. The main circuit substrate 3 and drive circuit substrate 5 are connected to each other via an internal connection lead 6. In addition, the drive circuit substrate 5 is supplied with external control signals and supplementary power supplies 17 to 19 and 37 via external connections, shown as leads 7 in the Figure.

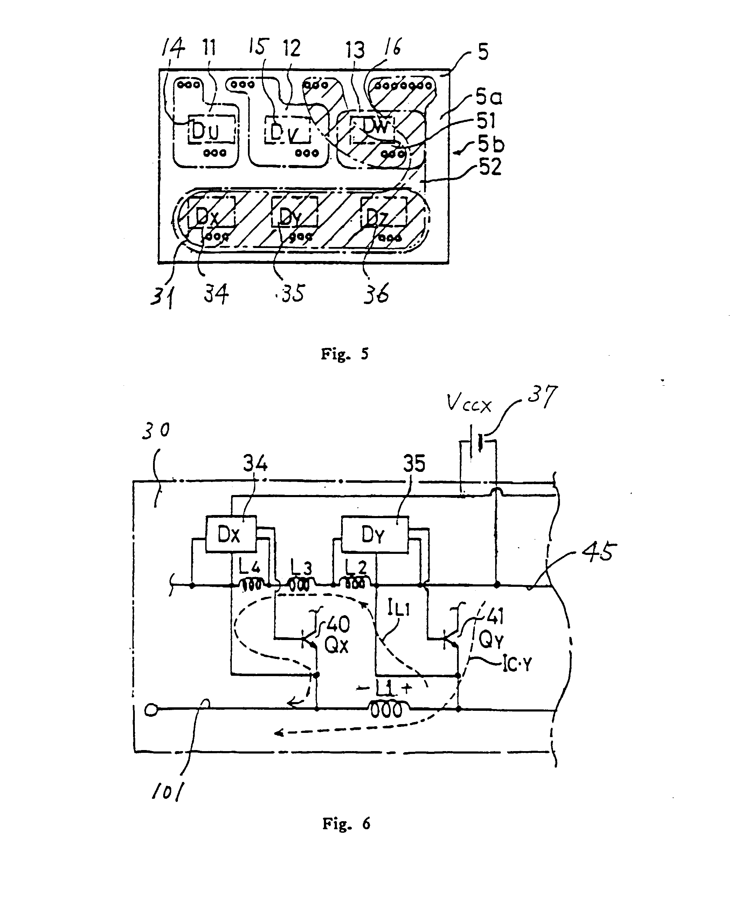

In conventional three-phase inverters, the drive circuit substrate 5 is configured as shown in Figure 5. That is, a double-sided printed circuit-type substrate is used as a drive circuit substrate 5 and the individual drive circuits 14 to 16 and 34 to 36 are mounted together on the upper surface 5a of the drive circuit substrate 5. In the individual drive circuits 14 to 16, various ground electrical potentials are connected to the various transistor emitters 20 to 22 provided in the upper-arm circuit 10. Thus, the conductor areas 11 to 13, on which the individual drive circuits are mounted, individually consist of a foil-like conductor on the upper surface 5a of the double-sided printed circuit-type substrate. In this case, the conductor areas 11, 12 for the individual drive circuits 14, 15 are integrally formed with a terminal part connected to the connection leads 6, 7. However, the conductor area 13 for the individual drive circuit 16 has a separately formed part, a conductor area 51, which extends to a terminal part connected to the connection leads 6, 7. The conductor area 51 consists of a foil-like conductor on the under-surface 5b of the double-sided printed circuit-type substrate.

In addition, in the individual drive circuits 34 to 36, respective ground electrical potentials are connected to a line 45 (see Figure 3) to which the respective emitters of the transistors 40 to 42 provided in the upper-arm circuit 30 are connected. The line 45 is a common ground electrical potential line used to provide a ground electrical potential which is equal to a common reference electrical potential for the negative electrode side. Thus, individual drive circuits 34 to 36 are mounted on a common conductor area 31. In addition, the conductor area 31 consists of a foil-like conductor on the upper surface 5a of the double-sided printed circuit-type substrate. In this case, the conductor area 31 has a separately formed part, a conductor area 52, which extends to a terminal part connected to connection leads 6, 7. The conductor area 52 consists of a foil-like conductor on the under-surface 5b of the double-sided printed circuit-type substrate.

That is, the conventional drive circuit substrate 5 shown in Figure 5 has conductor areas on both the upper surface 5a and the under-surface 5b. However, the double-sided printed circuit-type substrate enables the required electrical insulation to be sufficiently ensured between the individual drive circuits 14 to 16 and between the individual drive circuits 14 to 16 and the conductor area 31 composed of individual drive circuits 34 to 36.

In the three-phase inverter with the circuit configuration shown in Figure 3, the upper transistors 20 to 22 and lower transistors 40 to 42 alternately and periodically perform switching operations in response to control signals in order to convert the main DC power supply (Vd) to three-phase alternating currents. In this case, the respective upper-arm transistors 20 to 22 perform switching operations at time intervals corresponding to an electrical phase angle of 120° to keep three-phase alternating currents balanced. Furthermore, the group of the upper-arm transistors 20 to 22 and the group of lower-arm transistors 40 to 42 must alternatively perform switching operations at time intervals corresponding to an electrical phase angle of 180° so that opposing transistors, for example, transistors 20 and 40 will not be simultaneously turned on.

One of the most important matters to consider when configuring a semiconductor conversion device is the prevention of semiconductor switching element malfunctions. A malfunctioning semiconductor switching element will cause an arm to short, allowing excess electric currents to flow in the circuit. As a result, serious accidents such as the destruction of the semiconductor switching element or of equipment to be driven such as the electric motor may occur.

Recent advances in semiconductor technology have substantially reduced the malfunction of semiconductor switching elements, and have improved the reliability of semiconductor conversion devices. However, such malfunctions may also be caused by factors other than the semiconductor switching elements. Among them is the configuration of the drive circuit substrate. In a three-phase inverter, the electrical potentials of the emitters of the transistors 20 to 22 vary at different times in response to the above-mentioned switching operations of the transistors 20 to 22 and 40 to 42. Thus, in the drive circuit substrate provided in the three-phase inverter, the electrical potentials of the respective conductor areas connected to the transistors 20 to 22 are constantly changing.

For the configuration of the drive circuit substrate 5 provided in the prior art three-phase inverter described above, the conductor area 13 on which the individual drive circuit 16 is mounted and the conductor area 51 which is electrically connected thereto should be noted. That is, the conductor areas 13 and 52 or the conductor areas 51 and 12 have parts extending over the same areas of the substrate, but on different surfaces of the substrate with the insulated substrate of the double-sided printed circuit-type substrate in between. These opposing parts provides a relatively large parasitic capacitance because they have a configuration similar to that of a condenser. High-frequency currents easily pass through such a large parasitic capacitance. Thus, if the electrical potential of the emitter of the transistor 22 changes rapidly, high frequency currents may flow from conductor areas 13 and 51 to conductor areas 31 and 12, respectively, via the parasitic capacitance. High-frequency currents become a source of noise and may cause the transistors 21 and 40 to 42, which are driven by the individual drive circuits 15 and 34 to 36 mounted on the conductor areas 12, 31, to malfunction.

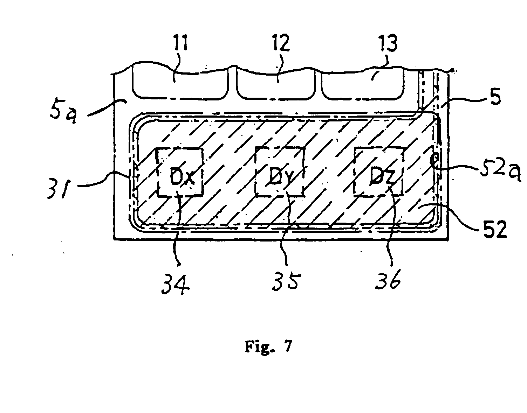

In addition, the current path in conductor area 31 is longer than that of conductor areas 11 to 13 because it has individual drive circuits 34 to 36 integrally mounted thereon. Furthermore, the current path of conductor area 52 is longer than that of the conductor area 31 because it must cover the whole range of the conductor area 31 and extend to the terminal part connected to the connection leads 6, 7. The conductor area 52 has a conductor area 52a (see Figure 7) for the common ground electrical potential line 45 formed therein. The conductor area 52a is formed in the peripheral part of the conductor area 52 surrounding the area of the conductor area 52, as shown in Figure 7. The ground electrical potential line 45 provides a common reference electrical potential for the individual drive circuits 34 to 36, and is electrically connected to the emitters of the transistors 40 to 42 and the negative electrode side of the supplementary power supply 37. Therefore, the ground electrical potential line 45 is electrically connected to the emitters of the respective transistors 40 to 42 and the main circuit line 101.

Thus, part of the main DC electric currents (Ic) branches off from the main circuit line 101 and flows to the ground electrical potential line 45. In particular, if the main DC electric currents (Ic) contain high frequency components, the inductance of the main circuit line 101 will cause more high frequency components to branch off to the ground electrical potential line 45. Figure 6 shows the important part of the ground electrical potential line 45 with the surrounding circuits in detail. As shown in this Figure, when the transistor 41 is switched on, DC-side main electric currents Ic_{Y} advancing to the negative electrode side of the main DC power supply (Vd) start to flow through the main circuit line 10 to which the emitter of the transistor 41 is connected. Immediately after the transistor 41 is switched on, the values of the main DC currents (Ic_{Y}) increase rapidly, indicating that the currents contain a large number of high-frequency components. In addition, there is always a parasitic inductance L1, either intentionally or unintentionally, on the main circuit line 101 between the part to which the emitter of the transistor 41 of the main circuit line 101 is connected and the part to which the emitter of the transistor 40 is connected. The existence of parasitic inductance (L1) enables a diverted flow I_{L1} to flow to the ground electrical potential line 45 as described below. That is, the diverted flow (I_{L1}) passes across the ground electrical potential line 45 when it starts from the main circuit line 101, passes through a junction with the emitter of the transistor 41, the ground electrical potential line 45, and a junction with the emitter of the transistor 40 in that order, finally returning to the main circuit line 101. The diverted flow (I_{L1}) generates a high-frequency voltage at parasitic inductances L2, L3, L4 of the ground electrical potential line 45. Thus, circuit elements having a ground electrical potential and connected between the inductances will have differing ground electrical potentials (the circuit elements are not shown but form the individual drive circuits 34, 35). These differing ground electrical potentials may prevent the original functions of the ground electrical potential, resulting in a malfunction of the circuit elements. In this case, such an unwelcome malfunction may occur in the transistors 40, 41 because the individual drive circuits 34, 35 deliver incorrect drive signals. This also applies to the individual drive circuit 36 for the transistor 42.

In view of the above problems, it is the objective of this invention to provide a semiconductor conversion device that avoids the disadvantages of the prior art in that it rarely malfunctions.

According to the present invention, the above objective is achieved by providing a semiconductor conversion device, having a three-phase bridge circuit configuration and consisting of a main circuit comprising a semiconductor switching element for each of at least two upper arms and two lower arms, and a drive circuit having individual drive circuits, which are mounted on the conductor areas of a foil-like conductor on a printed-circuit-type substrate, and are provided for the respective semiconductor switching elements to cause the semiconductor switching elements to perform switching operations, said drive circuit having on the same printed-circuit-type substrate the individual drive circuits which drive the semiconductor switching elements provided for the upper and/or lower arms, characterised in that the respective individual drive circuits driving the respective semiconductor switching elements for the upper or lower arms include respective individual reference electrical potential lines, which provide a dedicated reference electrical potential, and wherein the drive circuit consists of a common reference electrical potential line which provides a common reference electrical potential for the respective individual drive circuits of the upper or lower arms, while the respective individual reference electrical potential lines provided for the individual drive circuits of the upper and lower arms are each connected at a single point, respectively, to the common reference electrical potential line for the corresponding arm.

Preferably, the bridge circuit is a three-phase bridge circuit.

As described above, the drive circuit consists of common reference electrical potential lines, which provide common reference electrical potentials for the respective individual drive circuits for the upper or lower arms, the respective individual drive circuits driving the respective semiconductor switching elements for the upper or lower arms consist of individual reference electrical potential lines, which provide dedicated reference electrical potentials, and the individual reference electrical potential lines are each connected at only one point to the common reference electrical potential line, which provides the reference electrical potential for the corresponding arm.

Therefore, when the diverted flow of the main DC electric currents supplied from the main DC power supply (Vd) to the main circuit of the semiconductor conversion device passes across the common reference electrical potential line, the electrical potentials of the respective reference electrical potential lines become equal to the electrical potential of the point to which the common reference electrical potential line is connected. In this case, the electrical potential is uniform in each individual reference electrical potential line. This prevents the reference electrical potential from differing from one individual drive circuit to another. This in turn prevents the individual drive circuit from delivering incorrect drive signals due to the non-uniform electrical potential within the individual drive circuit.

An embodiment of the invention will now be describe in detail with reference to the accompanying drawings, in which:
Figure 1 is a schematic drawing illustrating the configuration of the drive-circuit substrate of a three-phase inverter according to this invention;
Figure 2 is an explanatory drawing illustrating the configuration of a ground electrical potential line with peripheral circuits in the important part of the three-phase inverter according to this invention;
Figure 3 is a circuit diagram illustrating the circuit configuration of the three-phase inverter;
Figure 4 is a sectional view illustrating the configuration of the three-phase inverter;
Figure 5 is a schematic drawing illustrating the configuration of the drive circuit substrate of a prior-art, three-phase inverter;
Figure 6 is a schematic drawing illustrating the configuration of a ground electrical potential line with peripheral circuits in the important part of a prior-art, three-phase inverter; and
Figure 7 is a schematic drawing illustrating the arrangement of the important part of the conductor area of the ground electrical potential line provided on the drive-circuit substrate of a prior-art, three-phase inverter.

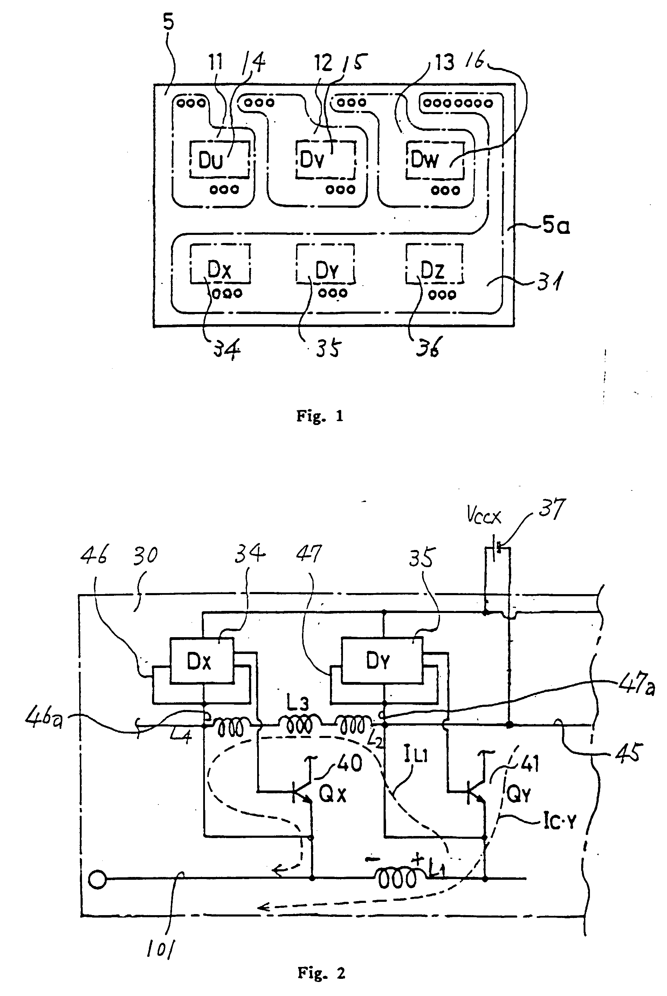

An embodiment according to this invention is explained below with reference to Figures 1 and 2 of the drawings.

Figure 1 shows the configuration of the drive circuit substrate of a three-phase inverter according to this invention. The three-phase inverter according to this invention has the same circuit configuration as the prior art described above in Figure 3. Therefore, no further description of the operation of the circuit is warranted. The three-phase inverter according to this invention consists of a main circuit substrate 3 having a configuration similar to that of the prior art described above in Figure 4, and a drive circuit substrate according to this invention on which individual drive circuits 14 to 16 and 34 to 36 are integrally mounted.

With reference to Figure 1, this invention is described in conjunction with a three-phase inverter, in which conventional bipolar NPN transistors are used as semiconductor switching elements, although it need not be limited to such an inverter. Similar effects can be obtained by using bipolar PNP transistors, MOSFETs, IGBTs, voltage-driven transistors or thyristors as the semiconductor switching elements.

In addition, Figure 2 is an explanatory drawing illustrating the configuration of a ground electrical potential line in the important part of a three-phase inverter according to this invention. As shown in Figure 2, the three-phase inverter consists of individual ground electrical potential lines 46, 47, which individually provide ground electrical potentials that are negative-electrode-side reference electrical potentials, for the individual drive circuits delivering drive signals to the lower-arm transistors 40, 41. In addition, the drive circuit substrate 5 provided in the three-phase inverter according to this invention has graphic or wiring patterns corresponding to the individual drive circuits 46, 47 formed thereon. These individual ground electrical potential lines 46, 47 are each connected at a single point on the connection lines 46a, 47a, respectively, to the ground electrical potential line 45. The individual drive circuit 36 delivering drive signals to the lower-arm transistor 42 also has an individual ground electrical potential line formed thereon, and this individual ground electrical potential line is connected at a single point to the ground electrical potential line 45 as in the individual drive circuits 34, 35, although this is not shown in Figure 2.

Thus, in the drive circuit according to this invention wherein dedicated individual ground electrical potential lines are provided for individual drive circuits 34 to 36, when a diverted flow (only a diverted flow I_{L1} is shown in Figure 2) of the main DC currents (Ic) supplied from the main DC power supply (Vd) to the three-phase inverter main circuit flow across the ground electrical potential line 45, the ground electrical potentials of the individual ground electrical potential lines 46 to 48 become equal to the electrical potential of the point of the common ground electrical potential line 45 to which the connection lines 46a, 47a, etc are connected. The electrical potential may vary among the individual ground electrical potential lines 46 to 48, but it is uniform within the same individual ground electrical potential line 46, 47, or 48. Thus, even if the flow across the parasitic inductances (L2, L3, L4) of the ground electrical potential line 45 is diverted, and the ground electrical potential varies among the individual drive circuits, it does not vary within each individual drive circuit 46, 47, 48. This prevents the individual drive circuits 46 to 48 from malfunctioning due to a non-uniform ground electrical potential within each individual drive circuit.

This invention has so far been described in conjunction with a case in which bipolar NPN transistors are used as semiconductor switching elements. However, if a three-phase inverter uses PNP transistors for at least the upper arm circuit part, the electrical potentials of the emitters of the transistors provided in the upper-arm circuit part will be common. Therefore, the malfunction of the individual drive circuits can be reduced by providing a dedicated individual reference electrical potential line which sets an emitter electrical potential for each individual drive circuit, as described above.

Furthermore, this invention has been described so far in conjunction with a case in which a semiconductor conversion device is an inverter; however, it need not be limited to such a device. That is, converters which convert alternating currents to direct currents can also be used as long as they are semiconductor conversion devices that include semiconductor switching elements in a main circuit with a bridge circuit configuration.

For individual drive circuits requiring a connection to a reference electrical potential, a uniform reference electrical potential within each individual drive circuit can be achieved by providing each individual drive circuit with a dedicated reference electrical potential line, which individually provides a reference electrical potential such as a ground electrical potential. This configuration allows individual drive circuits from malfunctioning due to the non-uniform reference electrical potential within each individual drive circuit.

Such a semiconductor conversion device can be applied to, for example, an inverter supplying a variable frequency alternating voltage to an electric motor to control it, while the decreased possibility of a malfunction of individual drive circuits serves to improve the reliability of the device and eliminate the likelihood of serious accidents such as arm short circuits.

## Claims

1. A semiconductor conversion device, having a three-phase bridge circuit configuration and consisting of a main circuit comprising a semiconductor switching element for each of at least two upper arms (10) and two lower arms (30), and a drive circuit having individual drive circuits (14 to 16, 34 to 36), which are mounted on the conductor areas of a foil-like conductor (5a) on a printed-circuit-type substrate (5), and are provided for the respective semiconductor switching elements (20 to 22, 40 to 42) to cause the semiconductor switching elements (20 to 22, 40 to 42) to perform switching operations, said drive circuit having on the same printed-circuit-type substrate (5) the individual drive circuits (14 to 16, 34 to 36) which drive the semiconductor switching elements (20 to 22, 40 to 42) provided for the upper and/or lower arms (10, 30), characterised in that the respective individual drive circuits (14 to 16, 34 to 36) driving the respective semiconductor switching elements (20 to 22, 40 to 42) for the upper or lower arms (10, 30) include respective individual reference electrical potential lines (46, 47), which provide a dedicated reference electrical potential, and wherein the drive circuit consists of a common reference electrical potential line (45) which provides a common reference electrical potential for the respective individual drive circuits (14 to 16, 34 to 36) of the upper (10) or lower (30) arms, while the respective individual reference electrical potential lines (46, 47) provided for the individual drive circuits (14 to 16, 34 to 36) of the upper (10) and lower (30) arms are each connected at a single point, respectively, to the common reference electrical potential line (45) for the corresponding arm.

## Patentansprüche

1. Halbleiter-Umwandlungsvorrichtung, die eine Dreiphasen-Brückenschaltungs-Konfiguration aufweist, und aus einer Hauptschaltung, die ein Halbleiterschaltelement für jeden von mindestens zwei oberen Zweigen (10) und zwei unteren Zweige (30) aufweist, und einer Treiberschaltung besteht, die einzelne Treiberschaltungen (14 bis 16, 34 bis 36) aufweist, die auf den Leiterbereichen eines folienartigen Leiters (5a) auf einem gedruckten Schaltungssubstrat (5) angebracht sind, und für die jeweiligen Halbleiterschaltelemente (20 bis 22, 40 bis 42) vorgesehen sind, um zu bewirken, daß die Halbleiterschaltelemente (20 bis 22, 40 bis 42) Schaltoperationen ausführen, wobei die Treiberschaltung auf demselben gedruckten Schaltungssubstrat (5) die einzelnen Treiberschaltungen (14 bis 16, 34 bis 36) aufweist, die die Halbleiterschaltelemente (20 bis 22, 40 bis 42) treiben, die für die oberen und/oder unteren Zweige (10, 30) vorgesehen sind, dadurch gekennzeichnet, daß die jeweiligen einzelnen Treiberschaltungen (14 bis 16, 34 bis 36), die die jeweiligen Halbleiterschaltelemente (20 bis 22, 40 bis 42) für die oberen oder unteren Zweige (10, 30) treiben, jeweilige einzelne elektrische Bezugspotential-Leitungen (46, 47) aufweisen, die ein zugeordnetes elektrisches Bezugspotential bereitstellen, und wobei die Treiberschaltung aus einer gemeinsamen elektrischen Bezugspotential-Leitung (45) besteht, die ein gemeinsames elektrisches Bezugspotential für jeweiligen einzelnen Treiberschaltungen (14 bis 16, 34 bis 36) der oberen (10) oder unteren (30) Zweige bereitstellt, während die jeweiligen einzelnen elektrischen Bezugspotential-Leitungen (46, 47), die für die einzelnen Treiberschaltungen (14 bis 16, 34 bis 36) der oberen (10) bzw. unteren (30) Zweige vorgesehen sind, jeweils an einem einzigen Punkt mit der gemeinsamen elektrischen Bezugspotential-Leitung (45) für den entsprechenden Zweig verbunden sind.

## Revendications

1. Dispositif de conversion à semi-conducteur, ayant une configuration de montage en pont triphasé et étant constitué d'un circuit principal comportant un élément de commutation à semi-conducteur pour chaque branche parmi au moins deux branches supérieures (10) et deux branches inférieures (30), et un circuit de commande ayant des circuits de commande individuels (14 à 16, 34 à 36), qui sont montés sur les zones conductrices d'un conducteur du type feuille (5a) situé sur un substrat du type pour circuit-imprimé (5), et sont agencés pour les éléments de commutation à semi-conducteur respectifs (20 à 22, 40 à 42) pour amener les éléments de commutation à semi-conducteur (20 à 22, 40 à 42) à effectuer des opérations de commutation, ledit circuit de commande ayant sur le même substrat du type pour circuit imprimé (5) les circuits de commande individuels (14 à 16, 34 à 36) qui commandent les éléments de commutation à semi-conducteur (20 à 22, 40 à 42) agencés pour les branches supérieures et/ou inférieures (10, 30), caractérisé en ce que les circuits de commande individuels respectifs (14 à 16, 34 à 36) commandant les éléments de commutation à semi-conducteur respectifs (20 à 22, 40 à 42) pour les branches supérieures ou inférieures (10, 30) comportent des lignes individuelles respectives de potentiel électrique de référence (46, 47), qui fournissent un potentiel électrique de référence affecté, et dans lequel le circuit de commande est constitué d'une ligne commune de potentiel électrique de référence (45) qui fournit un potentiel électrique de référence commun aux circuits de commande individuels respectifs (14 à 16, 34 à 36) des branches supérieures (10) ou inférieures (30), alors que les lignes individuelles respectives de potentiel électrique de référence (46, 47) prévues pour les circuits de commande individuels (14 à 16, 34 à 36) des branches supérieures (10) et inférieures (30) sont chacune reliées au niveau d'un point unique, respectivement, à la ligne commune de potentiel électrique de référence (45) de la branche correspondante.
